**Europäisches Patentamt**

**European Patent Office**

**Office européen des brevets**

(19)

(11) Veröffentlichungsnummer: **0 063 307**
**B1**

(12) # EUROPÄISCHE PATENTSCHRIFT

(45) Veröffentlichungstag der Patentschrift:
**07.01.88**

(21) Anmeldenummer: **82102918.8**

(22) Anmeldetag: **05.04.82**

(51) Int. Cl.⁴: **H 05 K 13/02,** H 05 K 13/00,
B 65 G 1/133, B 25 H 1/12

(54) **Teilezuführung.**

(30) Priorität: **07.04.81 DE 3114032**

(43) Veröffentlichungstag der Anmeldung:
**27.10.82 Patentblatt 82/43**

(45) Bekanntmachung des Hinweises auf die Patenterteilung:
**07.01.88 Patentblatt 88/1**

(84) Benannte Vertragsstaaten:
**AT BE CH DE FR GB IT LI NL SE**

(56) Entgegenhaltungen:
**DE - A - 2 716 548**
**DE - A - 2 856 109**

(73) Patentinhaber: **Stückler, Gerd, Birkenweg 18,
D-8151 Osterwarngau (DE)**

(72) Erfinder: **Stückler, Gerd, Birkenweg 18,
D-8151 Osterwarngau (DE)**

(74) Vertreter: **Weickmann, Heinrich, Dipl.-Ing. et al,
Patentanwälte Dipl.-Ing. H.Weickmann Dipl.-Phys.Dr.
K.Fincke Dipl.-Ing. F.A.Weickmann Dipl.-Chem. B. Huber
Dr.-Ing. H. Liska Dipl.-Phys.Dr. J. Prechtel
Postfach 860820, D-8000 München 86 (DE)**

**Beschreibung**

Die Erfindung betrifft eine Teilezuführung, insbesondere für einen Bestückungstisch für Schaltungsplatinen, umfassend eine Vielzahl von mit Teileaufnahmegefässen versehenen, mit den Gefässen ggf. einstückigen, länglichen Paletten, eine die im wesentlichen zueinander parallelen Paletten längs einer Bahnschleife mit zwei parallel nebeneinander liegenden zur Palettenlängsrichtung angenähert senkrechten Bewegungsbahnen und zwei die Bewegungsbahnen verbindenden Übergangsbahnen leitende Führung und einen Antrieb zur Bewegung der Paletten längs der Bahnschleife mit jeweils einem Antriebselement im Bereich der beiden Übergangsbahnen, welches an die jeweils in der Übergangsbahn befindliche Palette angreift, wobei in jeder Bewegungsbahn mehrere Paletten unter gegenseitiger seitlicher Anlage angeordnet sind und gemeinsam um eine Palettenbreite taktweise verschiebbar sind, unter gegensinniger Verschiebung der Paletten in der jeweils anderen Bewegungsbahn, und wobei in jeder Übergangsbahn eine Palette mittels des entsprechenden Antriebselements, ggf. einer Facheinteilung des Gefässes der Palette entsprechend, taktweise verschiebbar ist, bei gegensinniger Verschiebung der Palette in der jeweils anderen Übergangsbahn und stillstehenden, in Normalstellungen befindlichen Paletten in den Bewegungsbahnen.

Eine derartige Teilezuführung ist aus der DE-AS 2 716 548 bekannt. Diese Anordnung bietet die Möglichkeit, in einer Ebene (beispielsweise innerhalb des Innenraums der Tischplatte eines Bestückungstisches) eine Vielzahl von Teileaufnahmegefässen unterzubringen, da durch die in den Bewegungsbahnen seitlich aneinanderliegenden, länglichen Paletten die zur Verfügung stehende Fläche sehr gut ausgenutzt wird. Durch zyklische Verschiebung der Paletten längs der Bahnschleife ist es möglich, jede gewünschte Palette an einen Entnahmeort, beispielsweise im Bereich der Längenmitte einer Übergangsbahn zu bringen. Hierbei kann die Palette einer Facheinteilung des Gefässes entsprechend taktweise verschoben werden. Bei der Bewegung zweier Paletten längs der Übergangsbahn müssen die Paletten der Bewegungsbahnen in ihren Normalstellungen still stehen, da sie sonst in den Laufweg der beiden Paletten hineingeraten. Umgekehrt findet bei einer Bewegung der Paletten in den Bewegungsbahnen um jeweils eine Palettenbreite ebenfalls keine Palettenbewegung in den Übergangsbahnen statt. Bei der bekannten Teilezuführung wird dieser alternierende Antrieb der Paletten in den Bewegungsbahnen und den Übergangsbahnen durch einen zweigeteilten Antrieb erreicht. Die zur Verschiebung der Paletten längs der Übergangsbahnen dienenden beiden Antriebselemente werden von einer Zugkette gebildet, die an den Aussenlängsseiten der Paletten angreift. Der Verschiebung der Paletten innerhalb der Bewegungsbahnen um jeweils eine Palettenbreite dienen jeweils zwei Antriebskurbeln an je einem Ende der beiden Bewegungsbahnen, die an Stegen angreifen, die an den Palettenunterseiten ausgebildet sind. Dieser bekannte Antrieb ist mechanisch aufwendig, da insgesamt vier Antriebskurbeln sowie die Zugkette in aufeinander genau abgestimmter Weise angetrieben werden müssen. Fehler in der Synchronisierung können zu Schäden führen; wird beispielsweise die Zugkette zu spät angehalten, so stossen die von der Kette mitgenommenen Paletten an seitlichen Begrenzungen der Bewegungsbahnen hart an.

Demgegenüber ist es Aufgabe der Erfindung, eine Teilezuführung der eingangs genannten Art mit vereinfachtem Aufbau des Antriebes bereitzustellen.

Diese Aufgabe wird dadurch gelöst, dass in der Bahnschleife zwischen den Bewegungsbahnen und den Übergangsbahnen jeweils vorzugsweise abgeschrägte oder abgerundete Umlenkbahnen vorgesehen sind, die derart ausgebildet sind, dass die Paletten in Eingriff mit jeweils einem der Antriebselemente gelangen, wenn sie bei ihrer Bewegung von einer Bewegungsbahn zu einer Übergangsbahn eine vorgegebene Einklinkstellung innerhalb der entsprechenden Umlenkbahn erreichen und solange in Eingriff mit dem Antriebselement bleiben, bis sie bei ihrer Bewegung von der Übergangsbahn zu einer Bewegungsbahn eine vorgegebene Ausklinkstellung innerhalb der entsprechenden Umlenkbahn erreichen, wobei eine in einer der Einklink- bzw. Ausklinkstellungen einer Umlenkbahn befindliche Palette gegenüber ihrer Stellung am nächstgelegenen Ende der sich dieser Umlenkbahn anschliessenden Übergangsbahn um eine die Palettenbreite unterschreitende, jedoch nicht verschwindende Strecke zur jeweils anderen Übergangsbahn hin verlagert ist. Neben den beiden Antriebselementen werden keine weiteren, mit den Antriebselementen abwechselnd angetriebene, an die Paletten in den Bewegungsbahnen angreifende Antriebsteile benötigt. Wird nämlich eine Palette von einem der Antriebselemente an das Ende einer Übergangsbahn geschoben und anschliessend in die Umlenkbahn bis zur Ausklinkstellung, so erhält man eine Verschiebung dieser Palette sowie der ihr vorangehenden Paletten der anschliessenden Bewegungsbahn in Richtung zur anderen Übergangsbahn. Der Palettenbewegungszyklus wird dadurch fortgesetzt, dass die Palette am entgegengesetzten Ende der angesprochenen Bewegungsbahn bei dieser Verschiebungsbewegung soweit in die sich anschliessende Umlenkbahn geschoben wird, bis sie in Eingriff mit dem dortigen Antriebselement gelangt. Diese Palette kann dann von dem Antriebselement entlang dieser Übergangsbahn bewegt werden. Das jeweilige Ausklinken der Paletten innerhalb der Umlenkbahnen, vor Erreichen der nächstliegenden, genau eine Palettenbreite von der Übergangsbahn in Richtung der Palettenbreite entfernten Normalstellung, stellt sicher, dass die anschliessend in die Normalstellung bewegte Palette ausser Eingriff mit diesem Antriebselement steht und daher dessen Förderbewegung bei der Verschiebung der nächstfolgenden Palette längs der Übergangsbahn nicht behindert.

Es wird vorgeschlagen, dass die in Richtung der Palettenbreite genommene Verlagerungsstrecke einer aus einer Übergangsbahn in eine der Ausklinkstellungen bewegten Palette grösser ist, als die in Richtung der Palettenbreite genommene Verlagerungsstrecke einer aus einer Normalstellung am Ende einer Bewegungsbahn in eine der Einklinkstellungen bewegten Palette. Durch diese Massnahme erreicht man eine genaue Synchronisierung der Palettenbewegung. Nähert sich nämlich eine gerade von einem der Antriebselemente angetriebene Palette einer Ausklinkstelle, so gelangt die nachfolgende Palette in Eingriff mit dem Antriebselement noch ehe die vorlaufende Palette ausklinkt. Die Antriebszeiten aufeinanderfolgender Paletten überlappen also.

Um auszuschliessen, dass eine noch nicht eingeklinkte Palette vorzeitig, beispielsweise aufgrund von Erschütterungen, in Eingriff mit dem Antriebselement gelangt, wird vorgeschlagen, dass die Endbereiche der Paletten sowie ggf. die Umlenkbahnen derart ausgebildet sind, dass bei einer sich einer Einklinkstellung in Richtung zur nächstgelegenen Übergangsbahn unmittelbar nähernden Palette diese an der vorlaufenden, vom nächstliegenden Antriebselement angetriebenen Palette vorzugsweise über angeschrägte Paletteneckbereiche beider Paletten anliegt oder der vorlaufenden Palette mit geringem Abstandsspiel folgt derart, dass ein selbsttätiges Bewegen der nachlaufenden Palette in die Einklinkstellung durch die vorlaufende Palette verhindert ist.

Die antriebslose Bewegung einer Palette aus der Ausklinkstellung in die nächstfolgende Normalstellung kann durch ein bistabiles Element, beispielsweise ein an die Palette angreifendes, in einer Drehstellung vorgespanntes Hilfszahnrad erreicht werden, welches die Palette in die Normalstellung zu bewegen versucht. Ein derartiges Element erübrigt sich jedoch, wenn, wie vorgeschlagen, die Endbereiche der Paletten sowie ggf. die Umlenkbahnen derart ausgebildet sind, dass bei einer entlang einer Umlenkbahn zur folgenden Bewegungsbahn hin bewegten Palette, spätestens nach Erreichen der Ausklinkstellung, die nachfolgende Palette, vorzugsweise über angeschrägte Paletteneckbereiche beider Paletten, die vorlaufende Palette in die nächstfolgende Normalstellung zu schieben beginnt. Die Bewegung aufeinanderfolgender Paletten ist also derart synchronisiert, dass die Paletten während ihres Laufs entlang der Bahnschleife einander unmittelbar folgen und zwar so, dass eine im antriebslosen und daher kritischen Bereich zwischen einer Einklink- bzw. Ausklinkstellung und der nächstliegenden Normalstellung befindliche Palette in zuverlässiger Weise je nach Bewegungsrichtung in die Normalstellung bzw. in Eingriff mit dem Antriebselement gebracht wird, wobei ausgeschlossen ist, dass die Palette unbeabsichtigt beispielsweise aufgrund von Erschütterungen in Eingriff mit dem Antriebselement gelangt.

Um beim Aufeinandertreffen der angeschrägten Paletteneckbereiche zu Beginn ein relativ sanftes materialschonendes Aufeinanderstossen und anschliessend eine rasche Verschiebung der vorlaufenden Palette zu erreichen, wird vorgeschlagen, dass der Paletteneckbereich von einer von der Palettenseitenfläche ausgehenden Abschrägung gebildet ist, die über einen abgerundeten Bereich in die Palettenstirnfläche übergeht.

Während bei der eingangs aufgeführten bekannten Teilezuführung keine Bewegungsumkehr möglich ist, kann dies bei der erfindungsgemässen Teilezuführung einfach dadurch erreicht werden, dass die Ausklinkstellung mit der Einklinkstellung im wesentlichen identisch ist und ggf. in Richtung der Palettenbreite näher zur Bewegungsbahn als zur Übergangsbahn liegt. Durch die unsymmetrische Lage ist sichergestellt, dass eine Palette zu einem späteren Zeitpunkt ausklinkt als die nachfolgende Palette einklinkt.

Weiterhin wird vorgeschlagen, dass die Paletten jeweils mit einem in Palettenlängsrichtung länglichen Mitnahmeabsatz mit der Bewegungsbahn umlaufender Eingriffsfläche für die Antriebselemente ausgebildet sind und dass die im Bereich der Längenmitte der jeweiligen Übergangsbahn angeordneten Antriebselemente bei einer Bewegung der Paletten längs dieser Übergangsbahn an der dem Mittelpunkt der Bahnschleife zugewandten Seitenfläche des Mitnahmeabsatzes abrollen.

Dabei kann der Mitnahmeabsatz mit einer umlaufenden Verzahnung ausgebildet sein, die vorzugsweise aus zwei parallelen im wesentlichen geraden Längsverzahnungen und zwei diese verbindenden, vorzugsweise einen Halbkreisbogen beschreibenden oder spitz zulaufenden Endverzahnungen bestehen kann.

Der Mitnahmeabsatz kann jedoch auch anders ausgebildet sein, vorzugsweise als Stiftreihe.

Als Antriebselemente kommt eine Kette oder ein Zahnriemen in Frage, der um Umlenkrollen im Bereich der Längenmitten der Übergangsbahn geführt ist. In einer besonders einfachen Ausführungsform sind die beiden Antriebselemente jedoch von zwei Synchron angetriebenen Zahnrädern gebildet. Wenn beide Zahnräder mittels Zahnriemen miteinander verkoppelt sind, wird lediglich ein Motorantrieb benötigt.

Für den Fall, dass die Paletten auf einer im wesentlichen ebenen Unterlage aufliegen, wird vorgeschlagen, dass in der Unterlage zwei schleifenförmige, gegeneinander versetzt angeordnete, jeweils mit einer Führungsnut ausgebildete Nutenbahnen vorgesehen sind, deren jeweilige Form im wesentlichen der Form der Bahnschleife entspricht und dass jede Palette mit zwei Führungselementen versehen ist, die jeweils in eine zugeordnete Führungsnut eingreifen. Hierdurch erhält man eine einfach aufgebaute zuverlässige Führung der Paletten längs der Bahnschleife. Eine bevorzugte Ausführungsform ist dadurch gekennzeichnet, dass sich die Führungsnuten unter einem derart grossen Winkel schneiden, dass ein Einfädeln eines Führungselementes in die dem anderen Führungselement zugeordnete Führungsnut während des Betriebs im wesentlichen ausgeschlossen ist. Der Winkel beträgt dabei vorzugsweise etwa 70°.

Um einen ruhigen Lauf der Paletten zu gewährleisten und die Möglichkeit eines falschen Einfädelns auszuschliessen, wird vorgeschlagen, dass die Führungselemente jeweils ein in die Führungsnut eingesetztes Führungsschiffchen aufweisen.

Um ein Abheben der Paletten von der Unterlage auszuschliessen, wird vorgeschlagen, dass die Führungsnuten hinterschnitten sind.

Um besonders leichten Lauf der Paletten zu gewährleisten, wird vorgeschlagen, dass die Führungselemente mit drehbar gelagerten Führungsrollen ausgebildet sind, deren Durchmesser geringfügig kleiner ist als die Breite der Führungsnut bzw. der Nutmündung der hinterschnittenen Führungsnut und dass die Führungsrollen in die Führungsnut bzw. die Nutmündung eingreifen.

Die Erfindung wird im folgenden an Ausführungsbeispielen anhand der Zeichnung erläutert. Es zeigt:

Fig. 1 eine perspektivische Schemadarstellung eines eine erfindungsgemässe Teilezuführung aufnehmenden Bestückungstisches;

Fig. 2 eine Draufsicht auf den Bestückungstisch gemäss Fig. 1 bei abgenommener Deckplatte;

Fig. 3A bis 3C einen Ausschnitt der Anordnung nach Fig. 2 während unterschiedlicher Bewegungsphasen der Teilezuführung;

Fig. 4 eine Seitenansicht einer Palette;

Fig. 5 einen Detailschnitt entlang der Linie V–V in Fig. 2;

Fig. 6 eine Draufsicht in vergrössertem Massstab auf einen Kreuzungspunkt von Nutenbahnen;

Fig. 7 eine schematische Draufsicht auf einen Palettenkettenantrieb.

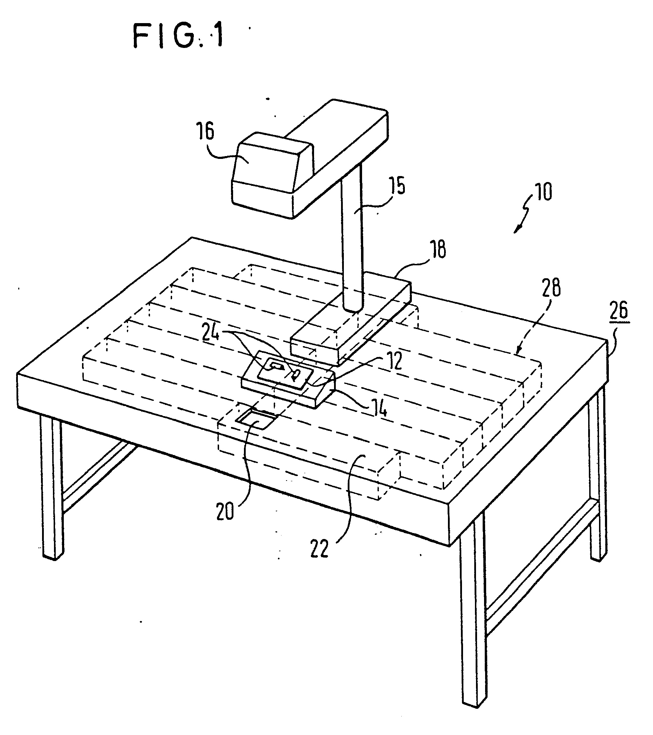

Der in Fig. 1 dargestellte Bestückungstisch 10 dient zur Bestückung einer Leiterplatte 12, welche an einem schematisch angedeuteten Halter 14 angebracht ist. Ein zur Anzeige des jeweiligen Bestückungsorts dienender Leuchtkopf 16 ist über einen Haltearm 15 und eine Grundplatte 18 an der Oberseite des Bestückungstisches 10 angebracht. Aus einer Entnahmeöffnung 20 in der oberen Abdeckplatte 22 des Bestückungstisches 10 können jeweils die als nächstes zur Bestückung der Leiterplatte 12 vorgesehenen Bauteile entnommen werden. Wie in Fig. 1 angedeutet, sind bereits zwei derartige Bauteile 24 an der Leiterplatte angebracht.

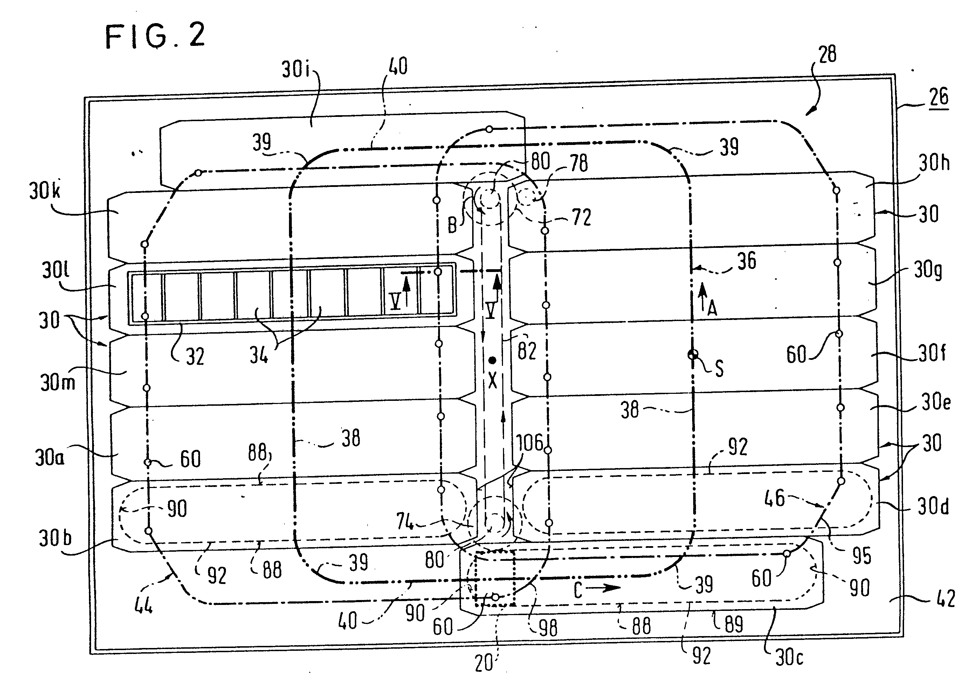

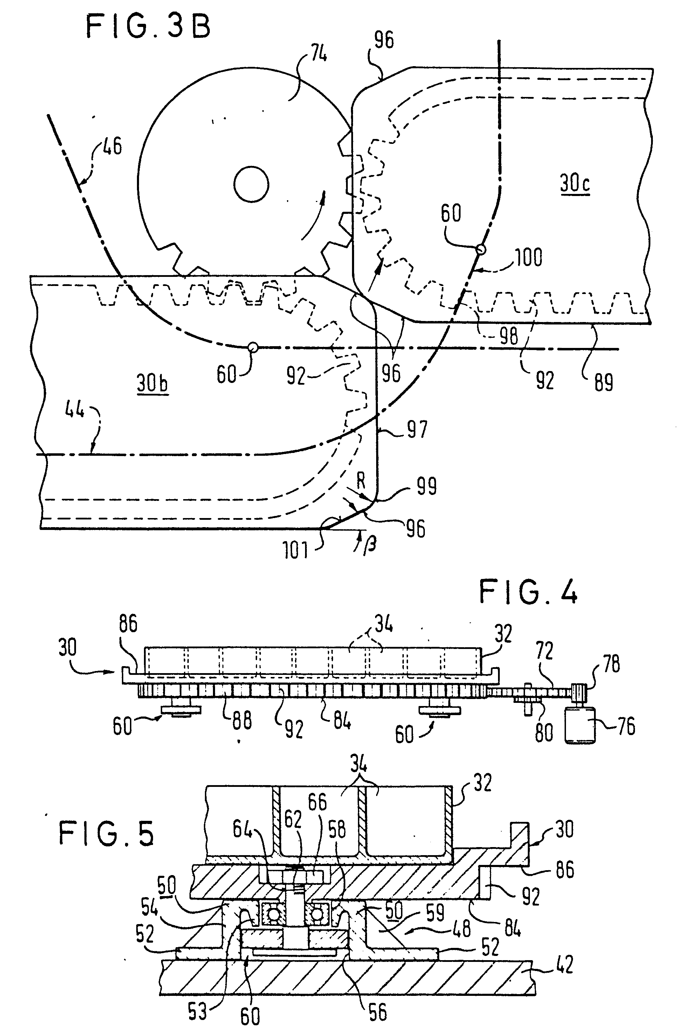

Die jeweils benötigten Bauteile werden über eine in Fig. 1 grob schematisch gestrichelt dargestellte, innerhalb der eigentlichen Tischplatte 26 angeordnete Teilezuführung 28 herbeigeschafft. Aus Fig. 2 ist der Aufbau der Teilezuführung 28 ersichtlich. Mit punktierter Linie ist die oberhalb der Teilezuführung 28 liegende Entnahmeöffnung 20 angedeutet. Die Teilezuführung 28 besteht aus einer Vielzahl (hier zwölf) von Paletten 30, die austauschbare Teileaufnahmegefässe 32 tragen. Wie aus Fig. 4 ersichtlich, ist jede Palette 30 mit einem durchgehenden Teileaufnahmegefäss 32 versehen, welches in eine Vielzahl (hier neun) von Fächern 34 unterteilt ist. Zur Vereinfachung der Darstellung ist in Fig. 2 lediglich eine Palette 30 mit einem derartigen Teileaufnahmegefäss 32 versehen. Anstelle eines einzigen durchgehenden Teileaufnahmegefässes 32 können auch mehrere einzelne Teileaufnahmegefässe nebeneinander auf die Paletten 30 gestellt werden. Die Abmessungen der Öffnungen der Fächer 34 entsprechen den Abmessungen der Entnahmeöffnung 20.

Die Paletten 30 werden während des Betriebs längs einer angenähert rechteckigen Bahnschleife geführt. Die in Fig. 2 mit einer Punkt-Punkt-Strich-Linie angedeutete Kurve 36, die die Bahn des Schwerpunkts S der Paletten 30 beschreibt, kann mit der Bahnschleife gleichgesetzt werden. Die in Fig. 2 von oben nach unten verlaufenden Teile der Bahnschleife 36 sollen als Bewegungsbahnen 38 und die von rechts nach links verlaufenden Teile als Übergangsbahnen 40 bezeichnet werden. Die Eckbereiche der Bahnschleife 36 sind abgerundet und werden als Umlenkbahnen 39 bezeichnet.

In den Bewegungsbahnen 38 liegen die Paletten 30 aneinander an und werden gemeinsam verschoben, wohingegen in den Übergangsbahnen jeweils eine Palette von einer Bewegungsbahn 38 zur anderen verschoben wird. Die Verschiebebewegungen in den beiden Übergangsbahnen 40 sind gegenläufig, ebenso die in den Bewegungsbahnen 38. Wie im folgenden noch ausgeführt werden wird, kann die Bahnschleife 36 abwechselnd in der einen wie auch in der anderen Richtung von den Paletten 30 abgefahren werden.

Wie aus den Fig. 2 bis 3C ersichtlich, führt die in der Übergangsbahn 40 befindliche Palette 30 eine lineare Verschiebebewegung durch, wobei sie entlang der dieser Palette zugewandten Seitenflächen der Paletten 30 der beiden Bewegungsbahnen 38 gleitet. Am Ende der Übergangsbahn 40 ist die Palette 30 gegenüber den Paletten 30 der anschliessenden Bewegungsbahn 38 noch nach innen versetzt angeordnet. Nach dem anschliessenden Durchlaufen der abgerundeten Umlenkbahn 39 ist die Palette 30 genau um eine Palettenbreite gegenüber ihrer Stellung in der vorangegangenen Übergangsbahn 40 versetzt und fluchtet nun mit den übrigen Paletten 30 der Bewegungsbahn 38.

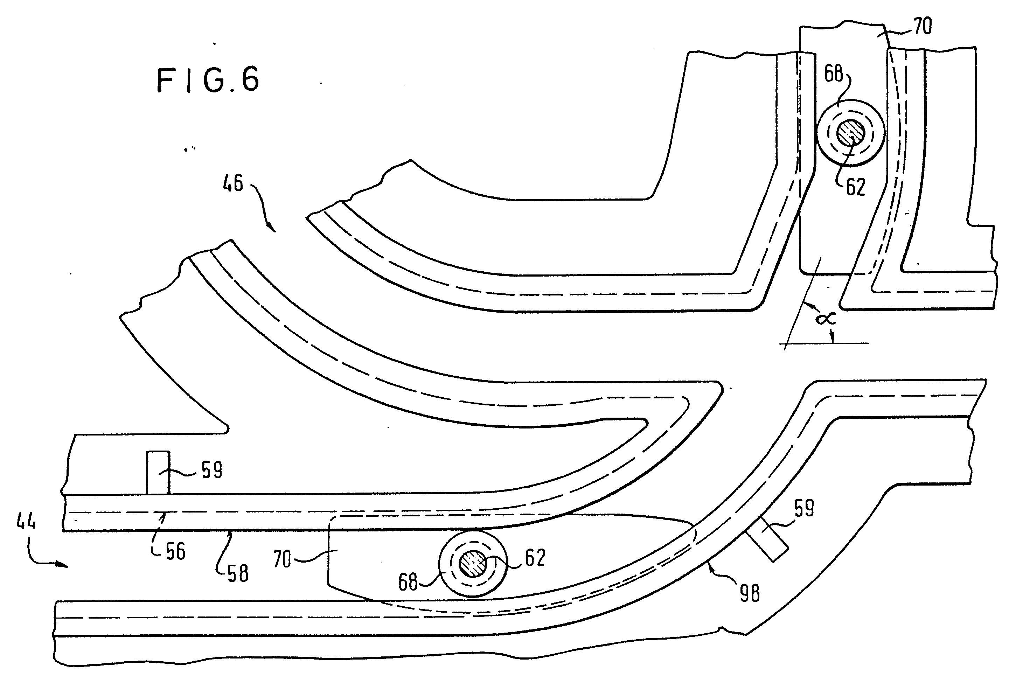

Um die Paletten 30 längs der Bahnschleife 36 zu führen und um in den Umlenkbahnen 39 eine noch zu behandelnde geringfügige Schwenkbewegung der Paletten 30 zu erhalten, sind zwei Nutenbahnen an einer ebenen Grundplatte 42 des Bestückungstisches 10 angebracht. Die Nutenbahnen sind in den Fig. 2 mit Strich-Punkt-Linien angedeutet, wobei die linke Nutenbahn mit 44, die rechte mit 46 beziffert ist. Jede Nutenbahn besteht aus einer Führungsnut 48, deren Aufbau aus den Fig. 5 und 6 hervorgeht. Zwei im Querschnitt im wesentlichen L-förmige Winkelelemente 50 sind mit Abstand voneinander auf der Grundplatte 42 mit voneinander abgewandten horizontalen Schenkeln 52 angebracht. Die freien Enden 53 der vertikalen Schenkel 54 sind zum jeweils anderen Winkel 50 hin etwa U-förmig umgebogen. Unterhalb der Enden 53 ist daher zwischen den Winkeln 50 eine hinterschnittene Führungsnut 56 ausgebildet und zwischen den Enden 53 eine Nutmündung 58. Zur Versteifung der Winkel 50 sind diese mit abgeschrägten Rippen 59 zwischen den Schenkeln 50 und 52 versehen.

Wie den Fig. 4 und 5 entnommen werden kann, trägt jede Palette 30 an ihrer Unterseite zwei Führungselemente 60, die in die Führungsnut 48 der Nutenbahn 44 bzw. der Nutenbahn 46 eingreifen. In Fig. 2 sind die Führungselemente 60 jeweils mit einem kleinen Kreis angedeutet.

Bei sich kreuzenden Nutenbahnen besteht die Gefahr, dass die Führungselemente 60 in die falsche Bahn einfädeln. Um diese Gefahr zu verringern, sind die beiden Nutenbahnen 46 und 48, wie Fig. 2 zeigt, derart gegeneinander versetzt, dass die Nutenbahnen 46 und 48 sich unter einem relativ grossen Winkel $\alpha$ schneiden, der etwa 70° beträgt (siehe auch Fig. 6).

Der Aufbau eines Führungselementes 60 geht aus Fig. 6 hervor. An einem abgestuften Haltebolzen 62, der in eine Palettenbohrung 64 eingesetzt und an seinem oberen Ende mittels einer Mutter 66 mit der Palette 30 starr verbunden ist, sind anschliessend an die Unterseite der Palette 30 eine Führungsrolle 68 sowie ein Führungsschiffchen 70 angebracht. Die kugelgelagerte Führungsrolle 68 greift in die bereits erwähnte Nutmündung 58 ein, wobei ihr Durchmesser geringfügig kleiner ist als die Breite der Nutmündung. Hierdurch wird ein reibungsarmer Lauf der Führungselemente 60 in den Führungsnuten 48 erreicht. Das ebenfalls drehbar gelagerte Führungsschiffchen 70 ist in Fig. 6 in vergrössertem Massstab in einer Draufsicht dargestellt. Das Führungsschiffchen 70 ist länglich ausgebildet. Die Breite des Führungsschiffchens 70 ist an die Breite der Führungsnut 56 angepasst. Damit es nicht zu Verklemmungen des Führungsschiffchens 70 in abgerundeten Teilen der Nutenbahnen 44 und 46 kommt, ist das Führungsschiffchen 70 nach aussen hin, d.h. weg vom Zentrum der Führungsbahnen 44 und 46, abgerundet. In Fig. 6 sind zwei Führungsschiffchen 70 dargestellt, deren Lage der in Fig. 2 dargestellten Palettenanordnung entspricht. Um zu verhindern, dass es bei einer Bewegung der untersten Palette 30 nach links zu einer Kollision des in der Nutenbahn 46 laufenden Schiffchens 70 dieser Palette 30 mit dem in Fig. 6 rechts oben dargestellten Schiffchens 70 kommt, sind die Schiffchen 70 an jeweils einem ihrer Enden entsprechend verkürzt.

Die Paletten 30 werden über zwei Zahnräder 72 und 74 angetrieben, die mit vertikaler Achse an der Grundplatte 42 drehbar gelagert sind. Eines der Zahnräder, das in Fig. 2 obere Zahnrad 72, ist mittels eines von einem Motor 76 angetriebenen Ritzels 78 verdrehbar. In der schematischen Darstellung der Fig. 4 ist an der Unterseite des Zahnrads 72 ein mit diesem drehfestes Hilfszahnrad 80 angedeutet. Ein entsprechendes Hilfszahnrad 80 ist auch am anderen Zahnrad 74 angebracht. Ein in Fig. 2 mit unterbrochener Linie angedeuteter Zahnriemen 82 sorgt für synchrone Bewegung beider Zahnräder 72 und 74.

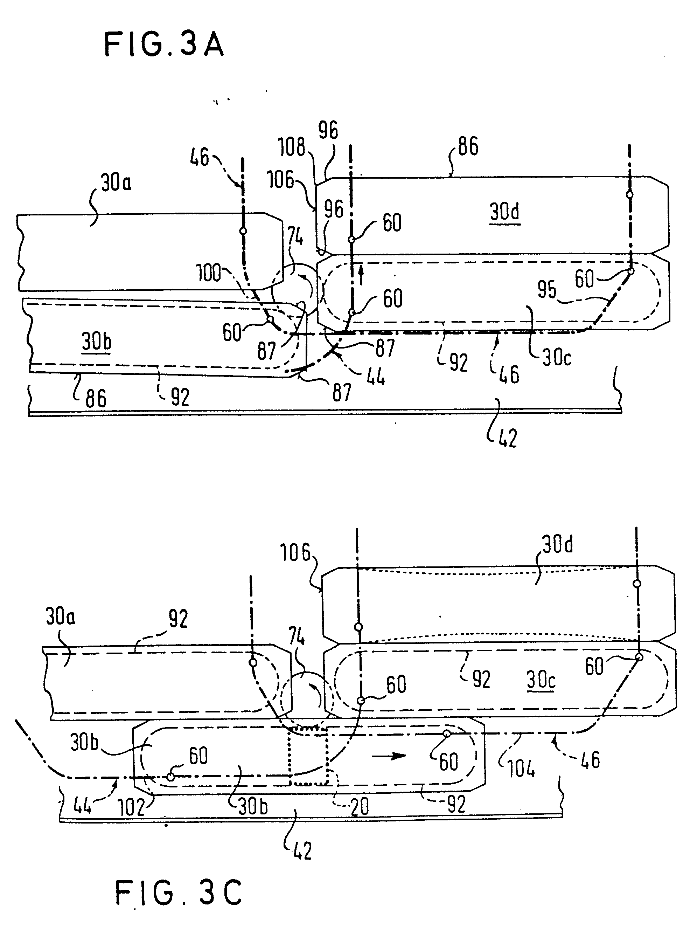

Die Paletten 30 sind jeweils mit einem Sockel oder Mitnahmeabsatz 84 ausgebildet, der an seinem oberen Ende einen nach aussen vorkragenden Randsteg 86 trägt. Der Sockel 84 hat zwei in Längsrichtung des Sockels 84 verlaufende zueinander parallele vertikale Seitenflächen 88 sowie zwei diese Flächen 88 verbindende Halbzylinderflächen 90 (siehe Fig. 2). Der Sockel 84 ist längs seines Umfangs, also entlang der Seitenflächen 88 und der Halbzylinderflächen 90 mit einer zum Eingriff in die Verzahnungen der Zahnräder 72 und 74 bestimmten Umfangsverzahnung 92 ausgebildet. In den Fig. 2 und 3A bis 3C ist bei einigen Paletten 30 die (bei diesen Ansichten nicht sichtbare) Umfangsverzahnung 92 mit unterbrochener Linie angedeutet. Im folgenden wird anhand der Fig. 2 bis 3C der Bewegungsablauf beim Palettentransport erläutert. Die Paletten 30 werden hierzu wie folgt durchnumeriert:

Die in Fig. 2 in der unteren Bewegungsbahn befindliche Palette wird mit 30c bezeichnet: die ihr im Gegenuhrzeigersinn folgenden Paletten mit 30d bis 30m sowie die beiden ihr im Gegenuhrzeigersinn vorangehenden Paletten werden mit 30b und 30a bezeichnet. Aufgrund der Symmetrie der Anordnung befinden sich die in bezug auf den Schleifenmittelpunkt X einander gegenüberliegenden Paletten (z.B. die Paletten 30b und 30h, die Paletten 30c und 30i sowie die Paletten 30d und 30k) in der gleichen Bewegungsphase. Der anhand der Fig. 3A bis 3C beschriebene Ablauf der Bewegung der Paletten 30a bis 30d entspricht daher der Bewegung der diesen gegenüberliegenden Paletten 30g bis 30k. Die Palettenbewegung erfolgt in Richtung des in Fig. 2 eingezeichneten Pfeils A; also im Gegenuhrzeigersinn.

In der in Fig. 2 dargestellten Ausgangsposition befindet sich die Palette 30c gerade am Ende ihrer taktweisen Bewegung längs der unteren Übergangsbahn 40 und liegt seitlich an der Palette 30d am unteren Ende der in Fig. 2 rechten Bewegungsbahn 36 an. Die Stellung dieser Palette 30d sowie der übrigen Paletten 30e bis 30h sowie 30k bis 30b wird ans Normalstellung bezeichnet. In der Normalstellung dieser Bewegungsbahn-Paletten können sich die beiden Übergangsbahn-Paletten 30c und 30i ungehindert längs der Übergangsbahn 40 hin- und her bewegen, wobei sie jedoch seitlich an den nächstliegenden Paletten der Übergangsbahnen anliegen. Bewirkt wird diese Bewegung durch die beiden Zahnräder 72 und 74, die in die Umfangsverzahnungen 92 der beiden Paletten eingreifen. Die Umfangsverzahnungen 92 der benachbarten Paletten 30b und 30d bzw. 30h und 30k sind ausser Eingriff mit dem Zahnrad 74 bzw. 72.

Wird nun das vom Ritzel 78 angetriebene obere Zahnrad 72 in Richtung des Pfeils B gedreht, nachdem aus dem unterhalb der Entnahmeöffnung 20 liegenden Fach 34 das entsprechende Bauelement entnommen worden ist, so dreht sich auch das über den Zahnriemen 82 mit dem Zahnrad 72 gekoppelte Zahnrad 74 im gleichen Sinne mit, was dazu führt, dass sich die Palette 30c (sowie dementsprechend die Palette 30i) weiter nach rechts in Richtung des Pfeils C bewegt, wobei sie sich nunmehr in der Umlenkbahn 39 befindet. Dabei gelangt das am inneren Ende der Palette 30c angeordnete Führungselement 60 in einen abgerundeten Eckbereich 98 der Nutenbahn 44, wohingegen das andere Führungselement 60 in einen vergleichsweise stärker abgewinkelten geradlinig verlaufenden Eckbereich 95 der Nutenbahn 46 einläuft. Das dem Zahnrad 74 ferne äussere Ende der Palette 30c führt daher eine geringfügige Schwenkbewegung im Gegenuhrzeigersinn durch. Dementsprechend werden auch die Palette 30d sowie die auf diese folgenden Paletten 30e bis 30h der rechten Bewegungsbahn 38 geschwenkt. Die Verzahnung des Zahnrads 74 greift dabei nicht mehr in den an der innen gelegenen Seitenfläche 88 ausgebildeten Abschnitt der Umfangsverzahnung 92 ein, sondern in den an diesen anschliessenden, an der Halbzylinderfläche 90 ausgebildeten Verzahnungsabschnitt. Bei einer weiteren Drehung des Zahnrads 74 wird auch das dem Zahnrad 74 nahe Ende der Palette 30c angehoben und mit ihr die Paletten 30d bis 30h. Dabei wird die oberste Palette 30h in die nächstfolgende Umlenkbahn 39 geschoben und gelangt alsbald in eine Einklinkstellung, in der das Zahnrad 72 in die Umfangsverzahnung 92 dieser Palette 30h eingreift. Währenddessen bleibt jedoch die Palette 30c weiterhin im Eingriff mit dem Zahnrad 74, da es seine Ausklinkstellung in der Bewegungsabfolge erst später erreicht. Da in bezug auf den Bewegungsablauf der Palette 30c die Palette 30i entspricht sowie der Palette 30h die Palette 30b, steht das Zahnrad 74 nunmehr in Eingriff mit den Paletten 30c und 30b sowie das Zahnrad 72 dementsprechend mit den Paletten 30h und 30i.

Fig. 3A zeigt einen Moment, in dem die Palette 30b bereits in vollem Eingriff mit dem Zahnrad 74 steht und von diesem nach unten rechts verschwenkt ist. Mit der Palette 30c steht das Zahnrad 74 noch in vollem Eingriff. Bei einer weiteren Drehung des Zahnrads 74 ergibt sich die in Fig. 3B dargestellte Situation, in der die Palette 30c unmittelbar vor dem Ausklinken aus dem Zahnrad 74 steht (Ausklinkstellung). In dieser Stellung bzw. unmittelbar nach dem Ausklinken besteht die Gefahr, dass es zu einem falschen Ineinandergreifen der Zähne («Zahnsalat») kommt,wenn sich die vom Zahnrad 74 nicht mehr angetriebene Palette entweder aufgrund einer plötzlichen Erschütterung oder bei einer Richtungsumschaltung des Antriebs wieder zum Zahnrad 74 zurück bewegt. Diese Gefahr wird dadurch beseitigt, dass die Palette 30c durch die ihr unmittelbar nachfolgende Palette 30b vorangeschoben wird und zwar bereits in einem Zeitpunkt, in dem noch ein sicherer Eingriff zwischen den Verzahnungen des Zahnrads 74 und der Palette 30c besteht. Für eine rasche Entfernung der angeschobenen Palette 30c vom Zahnrad 74 sorgt ein entsprechend geneigter geradliniger Abschnitt 100 des Eckbereichs 98 der Nutenbahn 44. Wie aus Fig. 3B zu entnehmen ist, befindet sich das dem Zahnrad 74 nähere Führungselement 60 der Palette 30c gerade in diesem Abschnitt 100, wenn die Palette 30c im Bereich ihrer Ausklinkstellung ist. Der Neigung des Abschnitts 100 entsprechend wird die Palette 30c von der nachfolgenden Palette 30b rasch vom Zahnrad 74 weg geschoben. Erfolgt bei gerade ausgeklinkter Palette 30c eine Richtungsumschaltung, so besteht ebenfalls nicht die Gefahr eines unkontrollierten Zusammentreffens der Verzahnungen von Zahnrad 74 und Palette 30c. Bei einer Richtungsumschaltung wird die Palette 30h (siehe Fig. 2), die bereits in Eingriff mit dem Zahnrad 72 steht, von diesem Zahnrad nach unten bewegt und über die dazwischen liegenden Paletten 30d bis 30g auch die Palette 30c. Die Palette 30b läuft der Palette 30c jedoch ggf. mit geringem Spiel nur soweit voraus, dass ein vorzeitiges Ineinandergreifen der Verzahnungen zuverlässig verhindert ist. Um das gegenseitige Anschieben der Paletten zu erleichtern und den Verschleiss gering zu halten, sind die Paletteneckbereiche in der in Fig. 3B dargestellten Weise abgeschrägt. An eine Palettenstirnfläche 97 schliesst sich an beiden Ecken jeweils ein abgerundeter Bereich 99 an. Diese Bereiche 99 gehen jeweils in eine Abschrägung 101 über, die mit der sich jeweils anschliessenden Palettenseitenfläche 89 jeweils einen Winkel β bilden. Anfangs berühren sich die aufeinanderfolgenden Paletten 30b und 30c an den abgerundeten Bereichen; anschliessend gleiten die Abschrägungen 101 aneinander ab, was zu der erwünschten Verschiebung der Palette 30c aus der in Fig. 3B gezeigten Ausklinkstellung in die Normalstellung gemäss Fig. 3C am unteren Ende der folgenden Bewegungsbahn 38 führt.

Inzwischen ist die Palette 30b in die Übergangsbahn 40 gelangt und kann nun ihrer Facheinteilung in Palettenlängsrichtung entsprechend unterhalb der Entnahmeöffnung 20 weiter nach rechts bewegt werden. Dabei besteht die Möglichkeit, dass das rechte Ende dieser Palette 30b das ggf. noch nicht weit genug nach oben verschwenkte äussere Ende der Palette 30c nach oben in die Normalstellung drückt. Um dies zu erleichtern, können die Paletten 30 mit einer leichten Taillierung (punktierte Umrisslinie der Palette 30d in Fig. 3C) versehen sein, um die Momente zu Beginn der Verschiebungsbewegung der Palette 30b in der Übergangsbahn 40 gering zu halten. Das äussere Ende der Palette 30c sowie die entsprechenden Enden der in der Bewegungsbahn 38 vorangehenden Paletten 30d bis 30g werden demnach in zwei Schritten nach oben geschwenkt. In einem ersten Schritt zu Beginn der Bewegung der Palette 30c läuft das äussere Ende dem inneren voraus, was auf die vergleichsweise grössere Steigung (Eckbereich 95) der dem Führungselement 60 am äusseren Palettenende zugeordneten Nutenbahn 46 zurückzuführen ist. Das zwischenzeitlich vom inneren Ende wieder überholte äussere Ende wird nach bereits erfolgtem Ausklinken des inneren Endes dann in dem zweiten Schritt von der nachfolgenden Palette nach oben geschoben. In einer Abwandlung der Erfindung kann auf einen der beiden Schritte verzichtet werden, wenn die durch den anderen Schritt erzielbare Schwenkbewegung entsprechend gross ist.

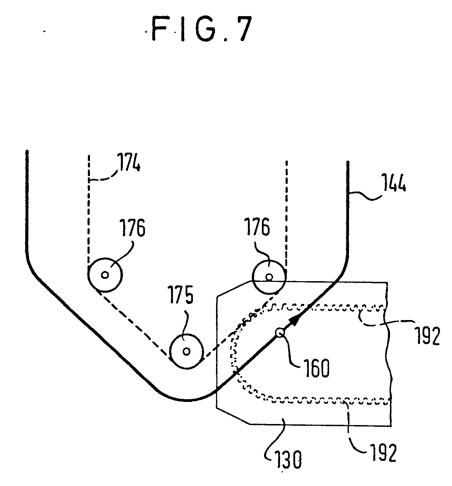

In Fig. 7 ist schematisch eine weitere Ausführungsform einer Teilezuführung gezeigt. Hierbei ist anstelle der beiden Zahnräder 74 und 72 eine Kette 174 vorgesehen, die in eine an diese Kette angepasste Umfangsverzahnung 192 einer Palette 230 angreift. Die Kette 174 ist in ihrem in Fig. 7 dargestellten unteren Teil (der dem oberen Teil entspricht) über eine mittlere Umlenkrolle 175 sowie zwei seitliche Umlenkrollen 176 geführt. In der dargestellten Anordnung befindet sich die Palette 130 gerade auf einer Umlenkbahn. Wird sie anschliessend in Pfeilrichtung bewegt, so führt der wachsende Abstand zwischen der Kette 174 und der Nutenbahn 144 dazu, dass die Umfangsverzahnung vor Erreichen der Bewegungsbahn ausser Kontakt mit der Kette 174 gelangt. Im übrigen entspricht das Funktionsprinzip der Teilezuführung gemäss Fig. 7 dem der vorstehend anhand der Fig. 1 bis 6 beschriebenen Teilezuführung.

Anstelle der an die Paletten an deren Innenseite angreifenden Kette 174 gemäss Fig. 7 kann auch eine um die Paletten aussen herumgeführte, an den Aussenseiten der Paletten angreifende, Kette eingesetzt werden. Ferner kann der die Umfangsverzahnung 92 tragende Absatz 84 auch ersetzt werden durch eine in Palettenlängsrichtung verlaufende Reihe senkrechter Stifte, in die den Zahnrädern 72 und 74 entsprechende Zahnräder eingreifen können.

**Patentansprüche**

1. Teilezuführung, insbesondere für einen Bestückungstisch für Schaltungsplatinen, umfassend eine Vielzahl von mit Teileaufnahmegefässen versehenen, mit den Gefässen ggf. einstückigen länglichen Paletten, eine die im wesentlichen zueinander parallelen Paletten längs einer Bahnschleife mit zwei parallel nebeinander liegenden, zur Palettenlängsrichtung angenähert senkrechten Bewegungsbahnen und zwei die Bewegungsbahnen verbindenden Übergangsbahnen leitende Führung und einen Antrieb zur Bewegung der Paletten längs der Bahnschleife mit jeweils einem Antriebselement im Bereich der beiden Übergangsbahnen, welches an die jeweils in der Übergangsbahn befindliche Palette angreift, wobei in jeder Bewegungsbahn mehrere Paletten unter gegenseitiger seitlicher Anlage angeordnet sind und gemeinsam um eine Palettenbreite taktweise verschiebbar sind, unter gegensinniger Verschiebung der Paletten in der jeweils anderen Bewegungsbahn, und wobei in jeder Übergangsbahn eine Palette mittels des entsprechenden Antriebselements, ggf. einer Facheinteilung des Gefässes der Palette entsprechend, taktweise verschiebbar ist, bei gegenseitiger Verschiebung der Palette in der jeweils anderen Übergangsbahn und stillstehenden, in Normalstellungen befindlichen Paletten in den Bewegungsbahnen und wobei ferner eine am Ende einer Übergangsbahn befindliche Palette an der nächstfolgenden Palette der sich anschliessenden Bewegungsbahn seitlich anliegt, dadurch gekennzeichnet, dass in der Bahnschleife (36) zwischen den Bewegungsbahnen (38) und den Übergangsbahnen (40) jeweils Umlenkbahnen (39) vorgesehen sind, die derart ausgebildet sind, dass die Paletten (30) in Eingriff mit jeweils einem der Antriebselemente gelangen, wenn sie bei ihrer Bewegung von einer Bewegungsbahn (38) zu einer Übergangsbahn (40) eine vorgegebene Einklinkstellung innerhalb der entsprechenden Umlenkbahn (39) erreichen und solange in Eingriff mit dem Antriebselement bleiben, bis sie bei ihrer Bewegung von der Übergangsbahn (40) zu einer Bewegungsbahn (38) eine vorgegebene Ausklinkstellung innerhalb der entsprechenden Umlenkbahn (39) erreichen, wobei eine in einer der Einklink- bzw. Ausklinkstellungen einer Umlenkbahn (Fig. 3B) befindliche Palette (30) gegenüber ihrer Stellung am nächstgelegenen Ende der sich dieser Umlenkbahn anschliessenden Übergangsbahn (40) um eine die Palettenbreite unterschreitende jedoch nicht verschwindende Strecke zur jeweils anderen Übergangsbahn (40) hin verlagert ist.

2. Teilezuführung nach Anspruch 1, dadurch gekennzeichnet, dass die in Richtung der Palettenbreite genommene Verlagerungsstrecke einer aus einer Übergangsbahn (40) in eine der Ausklinkstellungen bewegten Palette (30) grösser ist, als die in Richtung der Palettenbreite genommene Verlagerungsstrecke einer aus einer Normalstellung am Ende einer Bewegungsbahn (38) in eine der Einklinkstellungen bewegten Palette (30).

3. Teilezuführung nach Anspruch 1 oder 2, dadurch gekennzeichnet, dass die Endbereiche der Paletten mit angeschrägten Paletteneckbereichen (96) ausgebildet sind, zur gegenseitigen Anlage der Paletten (30) im Bereich einer Umlenkbahn (39).

4. Teilezuführung nach Anspruch 3, dadurch gekennzeichnet, dass der Paletteneckbereich (96) von einer von der Palettenseitenfläche (88) ausgehenden Abschrägung (101) gebildet ist, die über einen abgerundeten Bereich (99) in die Palettenstirnfläche (97) übergeht.

5. Teilezuführung nach einem der Ansprüche 1 bis 4, dadurch gekennzeichnet, dass die Ausklinkstellung bei Bewegung in einer Transportrichtung mit der Einklinkstellung bei Bewegung in der entgegengesetzten Transportrichtung identisch ist.

6. Teilezuführung nach einem der Ansprüche 1 bis 5, dadurch gekennzeichnet, dass die Ausklinkstellung in Richtung der Palettenbreite näher zur Bewegungsbahn (38) als zur Übergangsbahn (40) liegt.

7. Teilezuführung nach einem der Ansprüche 1 bis 6, dadurch gekennzeichnet, dass die Paletten (30) jeweils mit einem in Palettenlängsrichtung länglichen Mitnahmeabsatz (Sockel 84) mit in der Bewegungsbahnebene umlaufender Eingriffsfläche (Umfangsverzahnung 92) für die Antriebselemente (Zahnräder 72 und 74) ausgebildet sind, und dass die im Bereich der Längenmitte der jeweiligen Übergangsbahn (40) angeordneten Antriebselemente bei einer Bewegung der Paletten (30) längs der Übergangsbahn (40) an der dem Mittelpunkt (X) der Bahnschleife (36) zugewandten Seitenfläche des Mitnahmeabsatzes abrollen.

8. Teilezuführung nach Anspruch 7, dadurch gekennzeichnet, dass der Mitnahmeabsatz mit einer Umfangsverzahnung (92) ausgebildet ist, welche vorzugsweise aus zwei parallelen im wesentlichen geraden Längsverzahnungen und zwei diese verbindenden, vorzugsweise einen Halbkreisbogen beschreibenden oder spitz zulaufenden Endverzahnungen gebildet ist.

9. Teilezuführung nach Anspruch 8, dadurch gekennzeichnet, dass der Mitnahmeabsatz von einer Stiftreihe gebildet ist.

10. Teilezuführung nach einem der Ansprüche 1 bis 9, dadurch gekennzeichnet, dass die beiden Antriebselemente von einer Kette (174) oder Zahnriemen gebildet sind, die um Umlenkrollen (175) im Bereich der Längenmitte der Übergangsbahnen (40) geführt sind.

11. Teilezuführung nach einem der Ansprüche 7 bis 9, dadurch gekennzeichnet, dass die beiden Antriebselemente von zwei synchron angetriebenen, vorzugsweise mittels eines Zahnriemens (82) miteinander verkoppelten Zahnrädern (72, 74) gebildet sind.

12. Teilezuführung nach einem der Ansprüche 1 bis 11, wobei die Paletten auf einer im wesentlichen ebenen Unterlage aufliegen, dadurch gekennzeichnet, dass an der Unterlage (42) zwei schleifenförmige, gegeneinander versetzt angeordnete, jeweils mit einer Führungsnut (56) ausgebildete Nutenbahnen (46, 48) vorgesehen sind, deren jeweilige Form im wesentlichen der Form der Bahnschleife (36) entspricht und dass die Paletten (30) jeweils mit zwei Führungselementen (60) versehen sind, die jeweils in eine zugeordnete Führungsnut (46 bzw. 48) eingreifen.

13. Teilezuführung nach Anspruch 12, dadurch gekennzeichnet, dass sich die Führungsnuten (56) unter einem Winkel (α) von etwa 70° schneiden.

14. Teilezuführung nach Anspruch 12 oder 13, dadurch gekennzeichnet, dass die Führungselemente (60) jeweils ein in die Führungsnut (56) eingesetztes, schwenkbares, längliches Führungsschiffchen (70) aufweisen.

15. Teilezuführung nach einem der Ansprüche 12 bis 14, dadurch gekennzeichnet, dass die Führungsnuten (56) hinterschnitten sind.

16. Teilezuführung nach einem der Ansprüche 12 bis 15, dadurch gekennzeichnet, dass die Führungselemente (60) mit drehbar gelagerten Führungsrollen (68) ausgebildet sind, deren Durchmesser geringfügig kleiner ist als die Breite der Führungsnut (56) bzw. der Nutmündung (58) der hinterschnittenen Führungsnut (56) und dass die Führungsrollen (68) in die Führungsnut (56) bzw. die Nutmündung (58) eingreifen.

17. Teilezuführung nach einem der Ansprüche 1 bis 16, dadurch gekennzeichnet, dass das in Bezug auf den Schleifenmittelpunkt (x) innere Ende einer in einer der Umlenkbahnen (39) befindlichen Palette (30) mittels eines Führungselements (60) längs eines abgerundeten Eckbereichs (98) eines der beiden Nutenbahnen (44, 46) geführt ist, und dass das äussere Ende dieser Palette (30) mittels eines weiteren Führungselements (60) längs eines abgeschrägten Eckbereichs (95) geführt ist.

18. Teilezuführung nach Anspruch 17, dadurch gekennzeichnet, dass die länglichen Paletten an ihren Längsseiten tailliert sind (Fig. 3C).

19. Teilezuführung nach einem der Ansprüche 1 bis 18, dadurch gekennzeichnet, dass die Umlenkbahnen (39) im Bereich der Einklink- und der Ausklinkstellungen derart abgeschrägt sind (Abschnitt 100 der Nutenbahn 44), dass die den Antriebselementen jeweils nächstliegenden Palettenenden rasch in bzw. ausser Eingriff mit den Antriebselementen gelangen.

**Claims**

1. Parts feed system, especially for an equipping bench for circuit boards, comprising a plurality of elongated pallets provided with parts reception vessels and possibly in one piece with the vessels, a guide system conducting the substantially mutually parallel pallets along a track loop with two movement tracks lying parallel side by side and approximately perpendicular to the longitudinal direction of the pallets and two transfer tracks connecting the movement tracks and a drive system for moving the pallets along the track loop, with a drive element in the region of each of the two transfer tracks, which drive element acts on the pallet situated in the transfer track in each case, where in each movement track several pallets are arranged in mutual lateral contact and are displaceable in cadence in common by one pallet width, with oppositely directed displacement of the pallets in the other movement track in each case, and where in each transfer track a pallet is displaceable in cadence by means of the corresponding drive element, possibly in accordance with a compartmentation of the vessel of the pallet, with opposite displacement of the pallet in the other transfer track in each case and stationary pallets situated in standard positions in the movement tracks, and where furthermore a pallet situated at the end of a transfer track rests laterally on the next succeeding pallet of the adjoining movement track, characterised in that in the track loop (36) between the movement tracks (38) and the transfer tracks (40) in each case there are provided deflector tracks (39) which are formed so that the pallets (30) come into engagement each with one of the drive elements when in their movement from a movement track (38) to a transfer track (40) they reach a pre-determined engagement position within the corresponding deflector track (39) and remain in engagement with the drive element until in their movement from the transfer track (40) to a movement track (38) they reach a pre-determined disengagement position within the corresponding deflector track (39), a pallet (30) situated in one of the engagement or disengagement positions of a deflector track (Figure 3B) being shifted, in relation to its position at the nearer and of the transfer track (40) adjoining this deflector track, by a distance falling short of the pallet width but not negligible, towards the other transfer track (40) in each case.

2. Parts feed system according to Claim 1, characterised in that the displacement distance taken in the direction of the pallet width of a pallet (30) moved out of a transfer track (40) into one of the disengagement positions is greater than the displacement distance, taken in the direction of the pallet width, of a pallet (30) moved out of a standard position at the end of a movement track (38) into one of the engagement positions.

3. Parts feed system according to Claim 1 or 2, characterised in that the end zones of the pallets are formed with bevelled pallet corner zones (96) for mutual abutment of the pallets (30) in the region of a deflector track (39).

4. Parts feed system according to Claim 3, characterised in that the pallet corner zone (96) is formed by a bevel (101) which starts from the pallet side face (88) and merges by way of a rounded zone (99) into the pallet end face (97).

5. Parts feed system according to one of Claims 1 to 4, characterised in that the disengagement position in the case of movement in one transport direction is identical with the engagement position in the case of movement in the opposite transport direction.

6. Parts feed system according to one of Claims 1 to 5, characterised in that the disengagement position, in the direction of the pallet width, lies closer to the movement track (38) than to the transfer track (40).

7. Parts feed system according to one of Claims 1 to 6, characterised in that the pallets (30) are formed each with an engagement step (base 84) elongated in the pallet longitudinal direction, with engagement surface (circumferential toothing 92) extending around in the plane of the movement track, for the drive elements (toothed wheels 72 and 74), and in that the drive elements arranged in the region of the middle of the length of the respective transfer track (40) roll on the side face of the engagement step facing the centre point (X) of the track loop (36), in a movement of the pallets (30) along the transfer track (40).

8. Parts feed system according to Claim 7, characterised in that the engagement step is formed with a circumferential toothing (92) which is preferably formed from two parallel, substantially straight longitudinal toothings and two end toothings, preferably describing a semi-circular arc or converging acutely, which connect these longitudinal toothings.

9. Parts feed system according to Claim 8, characterised in that the engagement step is formed by a row of pins.

10. Parts feed system according to one of Claims 1 to 9, characterised in that the two drive elements are formed by a chain (174) or toothed belts which are guided around reversing pulleys (175) in the region of the middle of the length of the transfer tracks (40).

11. Parts feed system according to one of Claims 7 to 9, characterised in that the two drive elements are formed by two toothed wheels (72, 74) driven synchronously preferably coupled with one another by means of a toothed belt (82).

12. Parts feed system according to one of Claims 1 to 11, where the pallets lie on a substantially even base, characterised in that on the base (42) there are provided two groove tracks (46, 48) of loop form, arranged offset in relation to one another and each formed with a guide groove (56), the form of each of which corresponds substantially to the form of the track loop (36) and in that the pallets (30) are provided each with two guide elements (60) which engage each in an allocated guide groove (46 and 48 respectively).

13. Parts feed system according to Claim 12, characterised in that the guide grooves (56) intersect one another at an angle (α) of about 70°.

14. Parts feed system according to Claim 12 or 13, characterised in that the guide elements (60) each comprise a pivotable, elongated boat-shaped guide slide block (70) inserted into the guide groove (56).

15. Parts feed system according to one of Claims 12 to 14, characterised in that the guide grooves (56) are undercut.

16. Parts feed system according to one of Claims 12 to 15, characterised in that the guide elements (60) are formed with rotatably mounted guide rollers (68) the diameter of which is slightly smaller than the width of the guide groove (56) or the groove mouth (58) of the undercut guide groove (56) and in that the guide rollers (68) engage in the guide groove (56) or the groove mouth (58).

17. Parts feed system according to one of Claims 1 to 16, characterised in that the inner end, in relation to the loop centre point (x), of a pallet (30) situated in one of the deflector tracks (39) is guided by means of a guide element (60) along a rounded-off corner zone (98) of one of the two groove tracks (44, 46), and in that the outer end of this pallet (30) is guided by means of a further guide element (60) along a bevelled-off corner zone (95).

18. Parts feed system according to Claim 17, characterised in that the elongated pallets are waisted on their long sides (Figure 30).

19. Parts feed system according to one of Claims 1 to 18, characterised in that the deflector tracks (39) are bevelled off (section 100 of the groove track 44) in the region of the engagement and disengagement positions in such a way that the pallet ends lying in each case nearest to the drive elements come rapidly into and out of engagement with the drive elements.

**Revendications**

1. Dispositif d'alimentation en composants, notamment pour une table à équiper des plaquettes imprimées, comprenant une multiplicité de palettes oblongues munies de récipients récepteurs de composants et éventuellement solidaires avec les récipients, comprenant un dispositif de guidage dirigeant les palettes sensiblement parallèles entre elles le long d'une trajectoire en boucle présentant deux voies de déplacement situées parallèlement l'une à côté de l'autre et approximativement perpendiculaires au sens longitudinal des palettes, et deux voies de transfert reliant les voies de déplacement, et comprenant un dispositif d'entraînement pour déplacer les palettes le long de la trajectoire en boucle et qui présente un élément d'entraînement respectif dans la région de chacune des deux voies de transfert, élément qui agit sur la pallette se trouvant dans la voie de transfert respective, plusieurs palettes étant disposées en appui latéral mutuel dans chaque voie de déplacement et étant conjointement déplaçables par pas d'une largeur de palette, avec déplacement dans le sens contraire des palettes se trouvant dans l'autre voie de déplacement, et une palette étant, dans chaque voie de transfert, déplaçable par pas, correspondant éventuellement à une division en compartiments du récipient de la palette, au moyen de l'élément d'entraînement correspondant, avec déplacement dans le sens contraire de la palette se trouvant dans l'autre voie de transfert et avec les palettes dans les voies de déplacement étant stationnaires à des positions normales, et une palette se trouvant à l'extrémité d'une voie de transfert s'appuyant latéralement contre la palette consécutive de la voie de déplacement se raccordant à ladite voie de transfert, caractérisé en ce qu'il est prévu dans la trajectoire en boucle (36) des voies de renvoi respectives (39) entre les voies de déplacement (38) et les voies de transfert (40), voies de renvoi qui sont conformées de telle sorte que les palettes (30) entrent respectivement en prise avec un des éléments d'entraînement lorsque, lors de leur déplacement d'une voie de déplacement (38) à une voie de transfert (40), elles atteignent une position d'enclenchement prédéterminée à l'intérieur de la voie de renvoi (39) correspondante, et qu'elles restent en prise avec l'élément d'entraînement jusqu'à ce que, lors de leur déplacement de la voie de transfert (40) à une voie de déplacement (38), elles atteignent une position de désenclenchement prédéterminée à l'intérieur de la voie de renvoi (39) correspondante, une palette (30) se trouvant à une des positions d'enclenchement ou selon le cas de désenclenchement d'une voie de renvoi (figure 38) étant, par rapport à sa position à l'extrémité la plus proche de la voie de transfert (40) se raccordant à cette voie de renvoi, décalée vers l'autre voie de transfert (40) d'une distance inférieure à la largeur de palette mais cependant non infirme.

2. Dispositif d'alimentation en composants selon la revendication 1, caractérisé en ce que la distance de décalage – mesurée dans le sens de la largeur des palettes – d'une palette (30) déplacée depuis une voie de transfert (40) jusuq'à une des positions de désenclenchement est supérieure à la distance de décalage – mesurée dans le sens de la largeur des palettes – d'une palette (30) déplacée depuis une position normale à l'extrémité d'une voie de déplacement (38) jusqu'à une des positions d'enclenchement.

3. Dispositif d'alimentation en composants selon la revendication 1 ou 2, caractérisé en ce que les régions terminales des palettes sont conformées avec des zones d'angles de palettes (96) biseautées, en vue de l'appui mutuel des palettes (30) dans la région d'une voie de renvoi (39).

4. Dispositif d'alimentation en composants selon la revendication 3, caractérisé en ce que la zone d'angle de palette (96) est constituée par un biseautage (101) qui part de la face latérale (88) de la palette et qui se raccorde à la face frontale (97) de la palette par l'intermédiaire d'une région arrondie (99).

5. Dispositif d'alimentation en composants selon une des revendications 1 à 4, caractérisé en ce que la position de désenclenchement lors du déplacement dans un sens de transport est identique à la position d'enclenchement lors du déplacement dans le sens de transport opposé.

6. Dispositif d'alimentation en composants selon une des revendications 1 à 5, caractérisé en ce que la position de désenclenchement se situe, dans le sens de la largeur des palettes, plus près de la voie de déplacement (38) que de la voie de transfert (40).

7. Dispositif d'alimentation en composants selon une des revendications 1 à 6, caractérisé en ce que les palettes (30) sont chacune conformées avec un décrochement d'entraînement (socle 84) oblong dans le sens longitudinal des palettes et présentant une face de prise (denture périphérique 92) circulant dans le plan de la voie de déplacement, qui est destinée aux éléments d'entraînement (roues dentées 72 et 74), et en ce que les éléments d'entraînement disposés dans la région médiane longitudinale de chaque voie de transfert (40) roulent, lors d'un déplacement des palettes (30) le long de la voie de transfert (40), contre la face latérale du décrochement d'entraînement qui est tournée vers le centre (X) de la trajectoire en boucle (36).

8. Dispositif d'alimentation en composants selon la revendication 7, caractérisé en ce que le décrochement d'entraînement est conformé avec une denture périphérique (92) qui est de préférence constituée de deux dentures longitudinales parallèles et sensiblement droites et de deux dentures terminales reliant les dentures longitudinales et s'étendant en pointe ou de préférence décrivant un demi-arc de cercle.

9. Dispositif d'alimentation en composants selon la revendication 8, caractérisé en ce que le décrochement d'entraînement est constitué par une rangée de doigts.

10. Dispositif d'alimentation en composants selon une des revendications 1 à 9, caractérisé en ce que les deux éléments d'entraînement sont constitués par une chaîne (174) ou une courroie dentée, qui sont guidées autour de poulies de renvoi (175) dans la région médiane longitudinale des voies de transfert (40).

11. Dispositif d'alimentation en composants selon une des revendications 7 à 9, caractérisé en ce que les deux éléments d'entraînement sont constitués par deux roues dentées (72, 74) entraînées de manière synchrone et accouplées l'une à l'autre de préférence au moyen d'une courroie dentée (82).

12. Dispositif d'alimentation en composants selon une des revendications 1 à 11, dans lequel les palettes reposent sur un support sensiblement plat, caractérisé en ce qu'il est prévu sur le support (42) deux voies rainurées (46, 48) en forme de boucles, disposées en déport l'une par rapport à l'autre, munies chacune d'une rainure de guidage (56), et dont la forme respective correspond sensiblement à celle de la trajectoire en boucle (36), et en ce que les palettes (30) sont respectivement munies de deux éléments de guidage (60) qui s'engagent respectivement dans une rainure de guidage (46 ou 48) associée.

13. Dispositif d'alimentation en composants selon la revendication 12, caractérisé en ce que les rainures de guidage (56) sont sécantes à un angle (α) d'environ 70°.

14. Dispositif d'alimentation en composants selon la revendication 12 ou 13, caractérisé en ce que les éléments de guidage (60) présentent respectivement une navette de guidage (70) oblongue et pivotante, insérée dans la rainure de guidage (56).

15. Dispositif d'alimentation en composants selon une des revendications 12 à 14, caractérisé en ce que les rainures de guidage (56) sont contre-dépouillées.

16. Dispositif d'alimentation en composants selon une des revendications 12 à 15, caractérisé en ce que les éléments de guidage (60) sont conformées avec des rouleaux de guidage (68) montés rotatifs, dont le diamètre est légèrement inférieur à la largeur de la rainure de guidage (56) ou encore du débouché (58) de la rainure de guidage (56) contre-dépouillée, et en ce que les rouleaux de guidage (68) s'engagent dans la rainure de guidage (56) ou encore dans le débouché (58) de la rainure.

17. Dispositif d'alimentation en composants selon une des revendications 1 à 16, caractérisé en ce que l'extrémité intérieure – par rapport au centre (x) de la boucle – d'une palette (30) se trouvant dans une des voies de renvoi (39) est guidée au moyen d'un élément de guidage (60) le long d'une zone d'angle arrondie (98) d'une des deux voies rainurées (44, 46), et en ce que l'extrémité extérieure de cette palette (30) est guidée le long d'une zone d'angle biseautée (95) au moyen d'un autre élément de guidage (60).

18. Dispositif d'alimentation en composants selon la revendication 17, caractérisé en ce que les palettes oblongues sont entaillées sur leurs côtés longitudinaux (figure 3C).

19. Dispositif d'alimentation en composants selon une des revendications 1 à 18, caractérisé en ce que les voies de renvoi (39) sont, dans la région des positions d'enclenchement et de désenclenchement, biseautées (section 100 de la voie rainurée 44) de telle sorte que les extrémités des palettes respectivement les plus proches des éléments d'entraînement viennent en prise ou selon le cas hors de prise rapidement avec les éléments d'entraînement.

# FIG.1

FIG.2

0 063 307

# FIG.3A

# FIG.3C

# FIG. 3B

# FIG. 4

# FIG. 5

FIG.6

# F·IG.7